Europäisches Patentamt

European Patent Office

Office européen des brevets

(19)

(11) Veröffentlichungsnummer: **0 258 249**
**B1**

(12) **EUROPÄISCHE PATENTSCHRIFT**

(45) Veröffentlichungstag der Patentschrift: 30.05.90

(21) Anmeldenummer: 86903287.0

(22) Anmeldetag: 25.03.86

(86) Internationale Anmeldenummer:
PCT/EP86/00179

(87) Internationale Veröffentlichungsnummer:
WO 86/05943 09.10.86 Gazette 86/22

(51) Int. Cl.⁵: **H 05 K 13/00, B 65 G 1/127,**
**A 47 B 63/06**

(54) ABGABEGERÄT.

(30) Priorität: 26.03.85 DE 8508950 u
26.03.85 DE 8508949 u

(43) Veröffentlichungstag der Anmeldung:
09.03.88 Patentblatt 88/10

(45) Bekanntmachung des Hinweises auf die
Patenterteilung:
30.05.90 Patentblatt 90/22

(84) Benannte Vertragsstaaten:
DE FR GB IT

(56) Entgegenhaltungen:
EP-A- 5 513
DE-A-2 204 347
DE-U-8 508 949
DE-U-8 508 950
US-A-3 317 029

(73) Patentinhaber: ROYONIC ELEKTRONIK
PRODUKTIONSMASCHINEN GMBH
Danziger Strasse 2
D-8057 Eching/München (DE)

(72) Erfinder: SCHINDLER, Wolfgang
Danziger Strasse 2
D-8057 Eching/München (DE)

(74) Vertreter: Kern, Ralf M., Dipl.-Ing. et al
Kern, Lang & Partner Patent- und
Rechtsanwaltsbüro Postfach 14 03 29
D-8000 München 5 (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

## Beschreibung

Die vorliegende Erfindung bezieht sich auf ein Abgabegerät gemäß dem Oberbegriff des Anspruchs 1.

Für die Durchführung von Bestückungsvorgängen von Schaltungsplatinen werden heutzutage vielfach Bestückungstische verwendet, in deren Tischplatte eine Mehrzahl von Magazinkästen mit Aufnahmemulden angeordnet sind, wobei die für den Bestückungsvorgang erforderlichen elektrischen Bauteile sich in den verschiedenen Aufnahmemulden der Magazinkästen befinden. Mit Hilfe eines geeigneten Antriebs werden die mit Aufnahmemulden versehenen Magazinkästen innerhalb der Tischplatte des Bestückungstisches derart bewegt, daß gerade jene Aufnahmemulde, in welcher die für den Bestückungsvorgang erforderlichen elektrischen Bauteile vorhanden sind, in den Bereich einer innerhalb der Tischplatte des Bestückungstisches angeordneten Entnahmeöffnung gebracht wird.

Bei einem Bestückungstisch bekannter Bauweise sind dabei innerhalb der Tischplatte des Bestückungstisches zwölf Magazinkästen mit jeweils acht Aufnahmemulden vorgesehen, so daß auf diese Weise Bestückungsvorgänge mit bis zu 96 verschiedenen elektrischen Bauteilen mit einer Zugriffzeit von etwa 3 sec durchführbar sind. Es hat sich jedoch gezeigt, daß in manchen Anwendungsfällen derartiger Bestückungstische-—beispielsweise für die Durchführung von Reparaturvorgängen bereits bestückter Platinen oder Geräte oder zur Durchführung von Montagevorgängen komplizierter Geräte, beispielsweise Uhren oder für die kompakte Ersatzteillargerung kleiner Bauteile—das Vorsehen von in etwa 100 Aufnahmemulden mit relativ kurzer Zugriffzeit nicht ausreichend ist.

Aus dieser Situation heraus sind demzufolge bereits Abgabegeräte gebaut worden, bei welchen der Transport der mit Aufnahmemulden versehenen Magazinkästen nicht in horizontaler Richtung innerhalb der Tischplatte des Bestückungstisches, sondern in vertikaler Richtung durchgeführt wird, um auf diese Weise eine größere Anzahl von Aufnahmemulden vorsehen zu können. Die auf diese Weise sich ergebenden Abgabegeräte sind dabei ähnlich wie Paternosterförderer aufgebaut, indem beidseitig von dem betreffenden Abgabegerät entsprechende Endlosketten vorgesehen sind, mit welchen die mit entsprechenden Aufnahmemulden versehenen Magazinkästen entlang einer vertikal angeordneten Endlosschleife bewegbar sind (siehe beispielsweise DE—OS 22 04 347).

Bei bekannten Paternosterfördergeräten, so wie sie beispielsweise zur Personenbeförderung, zur Speicherung von Personenkraftwagen oder für die Aufnahme von Karteikästen bekannt sind, hängen die einzelnen Aufnahmebehälter mehr oder weniger frei schwingend an den den Vertikaltransport durchführenden Endlosketten. Dies führt jedoch dazu, daß derartige Fördereinrichtungen nur mit relativ geringer Geschwindigkeit angetrieben werden können, so daß die Zugriffzeit zu den jeweiligen Gegenständen relativ lang ist.

Im Hinblick auf die Erzielung kurzer Zugriffzeiten ist es bei auf dem Paternosterprinzip arbeitenden Abgabegeräten somit bereits bekannt, zusätzliche Führungsschienen vorzusehen, mit welchen eine Zwangsführung der entlang der Endlosketten bewegten Magazinkästen erreicht wird, um auf diese Weise selbst bei höheren Fördergeschwindigkeiten—unabhängig von der jeweiligen Position der Magazinkästen—eine horizontale Positionierung derselben zu erreichen. Es zeigt sich jedoch, daß derartige Zwangsführungen in Form von Führungsschienen einen erheblichen apparativen Aufwand erfordern und zudem im Bereich der kritischen Umlenkstellen nur sehr bedingt wirksam sind, so daß selbst im Fall des Vorsehens derartiger Zwangsführungen keine optimale Fördergeschwindigkeit erreicht werden kann. Bei relativ groß dimensionierten Abgabegeräten führt dies dazu, daß die sich ergebende Zugriffzeit zu den einzelnen Aufnahmemulden der Magazinkästen weiterhin zu wünschen übrig läßt.

Es ist demzufolge Aufgabe der vorliegenden Erfindung, das Abgabegerät der eingangs genannten Art dahingehend weiterzubilden, daß bei relativ einfachem mechanischen Aufbau selbst im Fall lang ausgelegter Endlosketten mit einer Vielzahl von mit Aufnahmemulden versehenen Magazinkästen eine relativ kurze Zugriffzeit zu jeder beliebigen Aufnahmemulde möglich ist.

Erfindungsgemäß wird dies dadurch erreicht, daß die der Halterung der Magazinkästen dienenden Elemente als drehbar gelagerte Halteelemente ausgebildet sind, welche mit Rastgliedern versehen sind, die in bezug auf die Endlosketten in vorgegebenen Winkelstellungen einrastbar sind.

Rastglieden versehen sind, die in bezug auf die Endlosketten in vorgegebenen Winkelstellungen einrastbar sind.

Vorteilhafte Weiterbildungen der Erfindung ergeben sich anhand der Unteransprüche.

Die Erfindung soll nunmehr anhand eines Ausführungsbeispiels näher erläutert und beschrieben werden, wobei auf die beigefügte Zeichnung Bezug genommen wird. Es zeigen:

Fig. 1 eine perspektivische Ansicht eines Abgabegeräts gemäß der Erfindung,

Fig. 2 eine seitliche Ansicht eines Abschnitts einer Endloskette des Abgabegerätes von Fig. 1 mit dem daran befestigten Halteelement,

Fig. 3 eine seitliche Schnittansicht eines Umlenkkettenrades für die in Fig. 2 dargestellte Endloskette des Abgabegerätes von Fig. 1 und

Fig. 4 eine schematische Ansicht—teils im Schnitt—des Konsolenteils des Abgabegeräts von Fig. 1.

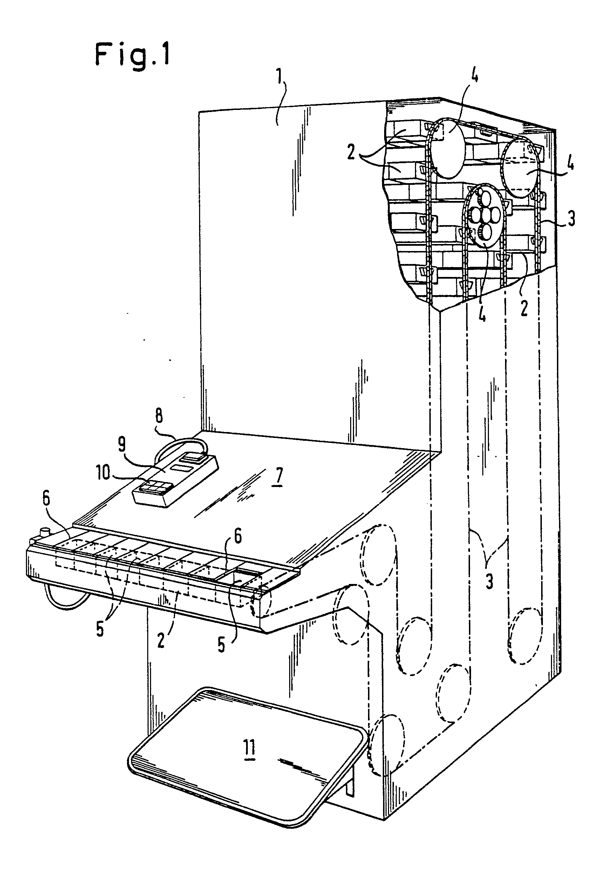

Fig. 1 zeigt ein Abgabegerät gemäß der Erfindung, welches mit einem schrankähnlichen, äußeren Gehäuse 1 versehen ist, innerhalb welchem bis zu 74 Magazinkästen 2 mit Hilfe entsprechender seitlich von den Magazinkästen 2 angeordneten Endlosketten 3 entlang eines meanderförmig ausgelegten Bewegungspfades bewegbar sind. Die beiden Endlosketten 3 sind dabei über entsprechende Umlenkkettenräder 4 geführt, wobei die Umlenkung der Endlosketten 3 an diesen Umlenkkettenrädern 4 wahlweise 90 oder 180° beträgt. Der Antrieb der beiden Endlosketten 3 erfolgt mit Hilfe eines nicht dargestellten Antriebmotors, welcher zweckmäßigerweise in Form eines drehzahlgesteuerten Drehstrommotors ausgebildet ist. Im Bereich der beiden Endlosketten 3 sind ferner noch zwei nicht dargestellte Spannmechanismen vorgesehen, mit welchen die um die Umlenkräder 4 geführten Endlosketten 3 in einem straff gespannten Zustand gehalten werden können.

Entsprechend Fig. 1 ist jeder Magazinkasten 2 mit acht nebeneinander angeordneten Aufnahmemulden 5 versehen, welche zweckmäßigerweise in Form von Einsätzen ausgebildet sind, die in die Magazinkästen 2 einsetzbar sind. Eine derartige Anordnung erlaubt dabei die raschere Durchführung eines erforderlichen Nachfüllvorganges bei Entleerung bestimmter Aufnahmemulden 5, sowie das Vorsehen von Aufnahmemulden mit doppelter oder dreifacher Breite, um auf diese Weise Bauteile größerer Abmessungen oder eine größere Anzahl von Bauteilen unterbringen zu können.

Die Entnahme der einzelnen Bauteile aus den Aufnahmemulden 5 der Magazinkästen 2 erfolgt im Bereich eines länglichen Entnahmefensters 6, welches im oberen Bereich eines pultförmigen Ansatzes 7 des äußeren Gehäuses 1 vorgesehen ist. Um jeweils einen Magazinkasten 2 in den Bereich des länglichen Entnahmefensters 6 bringen zu können, sind die innerhalb des äußeren Gehäuses 1 angeordneten Umlenkkettenräder 4 für die Endlosketten 3 derart angeordnet, daß innerhalb des pultförmigen Ansatzes 7 des äußeren Gehäuses 1 über eine kurze Wegstrecke hinweg ein horizontaler Transport der Magazinkästen 2 zustande kommt.

Im Bereich das einen Zugriff zu den acht nebeneinander angeordneten Aufnahmemulden 5 jeweils eines Magazinkastens 2 erlaubenden Entnahmefensters 6 ist zusätzlich noch ein über ein Anschlußkabel 8 angeschlossenes Eingabegerät 9 mit entsprechenden Tasten 10 vorgesehen, mit welchem manuell einzelne Magazinkästen 2 bzw. Aufnahmemulden 5 ansteuerbar sind, um auf diese Weise beispielsweise einen Nachfüllvorgang durchführen zu können. Ansonsten erfolgt die Steuerung des Abgabegerätes, unmittelbar von der Steuerelektronik eines beispielsweise unmittelbar daneben angeordneten Bestückungstisches, so daß auf diese Weise ein Zugriff zu elektronischen Bauteilen möglich ist, welche aus Platzgründen nicht innerhalb der Tischplatte des eigentlichen Bestückungstisches eingespeichert werden können.

Um das jeweilige Abgabegerät unmittelbar auch für die Durchführung von Bestückungsvorgängen einsetzen zu können, ist die Tiefe des pultförmigen Ansatzes 7 des Gehäuses 1 derart gewählt, daß auf demselben eine nicht dargestellte dynamische Leuchtpunktanzeige montiert werden kann, so wie sie beispielsweise in der DE—PS 27 16 548 beschrieben ist. Mit dieser Leuchtpunktanzeige lassen sich dabei die jeweiligen Bestückungsteile für die verschiedenen Bauteile optisch auf der zu bestückenden Platine anzeigen, welche mittels nicht dargestellter Halteelemente auf der oberen Fläche des pultförmigen Ansatzes 7 eingespannt ist. Die Höhe des pultförmigen Ansatzes 7 sowie einer zusätzlichen Fußstütze 11 sind derart eingestellt, daß ein möglichst ergonomisches Arbeiten an dem Abgabegerät möglich ist.

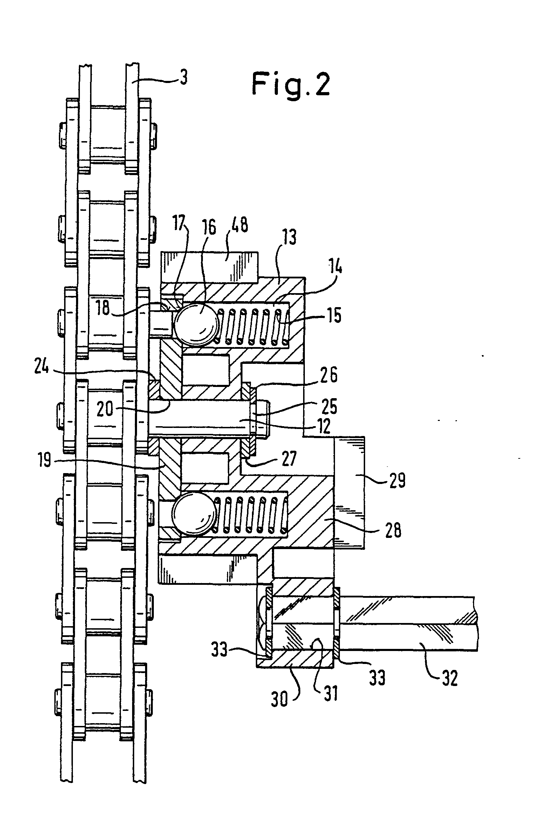

Um die einzelnen Magazinkästen 2 mit ihren Aufnahmemulden 5 während ihres vertikalen und horizontalen Transportes innerhalb des äußeren Gehäuses 1 jeweils in einer horizontalen Position zu halten, sind die beiden Endlosketten 3 gemäß Fig. 2 in regelmäßigen Abständen mit vorspringenden Zapfen 12 versehen, auf welchen Halteelemente 13 drehbar gelagert sind. Diese Halteelemente 13 sind jeweils mit zwei um 180° gegeneinander versetzten, zylindrischen Kammern 14 versehen, in welchen jeweils eine Druckfeder 15 angeordnet ist, die gegen eine ebenfalls innerhalb der betreffenden zylindrischen Kammer 11 angeordnete Rastkugel 16 drückt. Mit Hilfe der betreffenden Druckfedern 15 werden die beiden Rastkugeln 16 in konische Erweiterungen 17 von Bohrungen 18 gedrückt, welche innerhalb einer aus gehörtetem Stahl bestehenden Scheibe 19 angeordnet sind. Diese Scheiben 19 besitzen dabei jeweils eine mittige Bohrung 20, durch welche der der Lagerung des Halteelementes 13 dienende Zapfen 12 der betreffenden Endloskette 3 hindurchgeführt ist. Die Scheiben 19 sind dabei mit vier jeweils um 90° gegeneinander versetzten Bohrungen 18 versehen, so daß die unter dem Einfluß der Druckfedern 15 stehenden Rastkugeln 16 jeweils um 90° versetzt gegenüber der entsprechenden Scheibe 19 verrastbar sind. Der Kettenbolzen 21 der Endloskette 3, welcher jeweils dem mit dem Zapfen 12 versehenen Kettenbolzen 22 benachbart ist, ist mit einem weiteren Zapfen 23 kürzerer Länge versehen, welcher zum Teil in eine der Bohrungen 18 der Scheibe 19 hineinragt, wodurch erreicht wird, daß die Scheibe 19 jeweils in Längsrichtung der Endloskette 3 ausgerichtet ist, während das auf demselben Zapfen 12 drehbare Halteelement 13 je nach dem Rasteingriff der unter dem Einfluß der Druckfedern 15 stehenden Rastkugeln 16 eine beliebige, jeweils um 90° versetzte Position in bezug auf die Scheibe 19 und damit die Endloskette 3 einnehmen kann.

Um das jeweilige Halteelement 13 gegenüber der Endloskette 3 positionsmäßig zu fixieren, ist auf den Zapfen 12 zusätzlich eine Paßscheibe 24 aufgeschoben, welche die Scheibe 19 und damit das Halteelement 13 in einem genau vorgegebenen Abstand gegenüber der jeweiligen Endloskette 3 hält. Im Bereich des freien Endes des Zapfens 12 ist schließlich noch eine Ringnut 25 vorgesehen, in welche ein Sicherungsring 26 eingesetzt ist, der wiederum auf eine Scheibe 27 drückt, mit welcher das Halteelement 13 auf dem Zapfen 12 gehalten wird.

Die einzlenen Halteelemente 13 sind in Richtung der Mitte des Abgabegerätes hin mit jeweils einem horizontal verlaufenden Vorsprung 28 versehen, auf welchem seitlich an den Magazinkästen 2 vorgesehene nicht dargestellte Stege zum Aufliegen gelangen. Zusätzlich sind die Halteelemente 13 mit zwei vertikal angeordneten, parallel zueinander verlaufenden Stegen 29 versehen, welche in entsprechenden Vertikalnuten der Magazinkästen 2 zum Eingreifen gelangen, so daß auf diese Weise eine genaue Positionsfixierung der Magazinkästen 2 in bezug auf die Halteelemente 13 erfolgt. Der gegenseitige Abstand der zwei vertikalen Stege 29 der Halteelemente 13 ist fernerhin auf der rechten und linken Seite des Abgabegerätes unterschiedlich gewählt, so daß die Magazinkästen 2 nur jeweils in einer Position zwischen zwei Halteelementen 13 eingesetzt werden können.

Die Halteelemente 13 besitzen nach unten hin jeweils einen Ansatz 30, durch welchen eine Vierkantbohrung 31 hindurchgeführt ist. Durch diese innerhalb der Vorsprünge 28 der Halteelemente 13 vorgesehenen Vierkantbohrungen 31 sind Stangen in Form von Vierkantstäben 32 hindurchgeführt, welche mit Hilfe entsprechender Sicherungsringe 33 gegenüber den Halteelementen 13 positionsmäßig fixiert sind. Mit Hilfe dieser Vierkantstäbe 32 werden jeweils zwei der Aufnahme eines Magazinkastens 2 dienende Halteelemente 13 untereinander verbunden, wodurch erreicht wird, daß einerseits die beiden Endlosketten 3 in einem genau vorgegebenen Abstand zueinander geführt werden, während anderseits ein Verkippen der Halteelemente 13 unter der Last der Magazinkästen 2 verhindert wird.

Die bischer beschriebenen Mäßnahmen der Fig. 2 dienen dazu, daß die einzelnen Magazinkästen 2 entlang gerade verlaufender, horizontaler oder vertikaler Strecken der Endlosketten 3 derart geführt werden, daß die oberen Flächen der Aufnahmemulden 5 der Magazinkästen 2 jeweils in horizontaler Position gehalten werden.

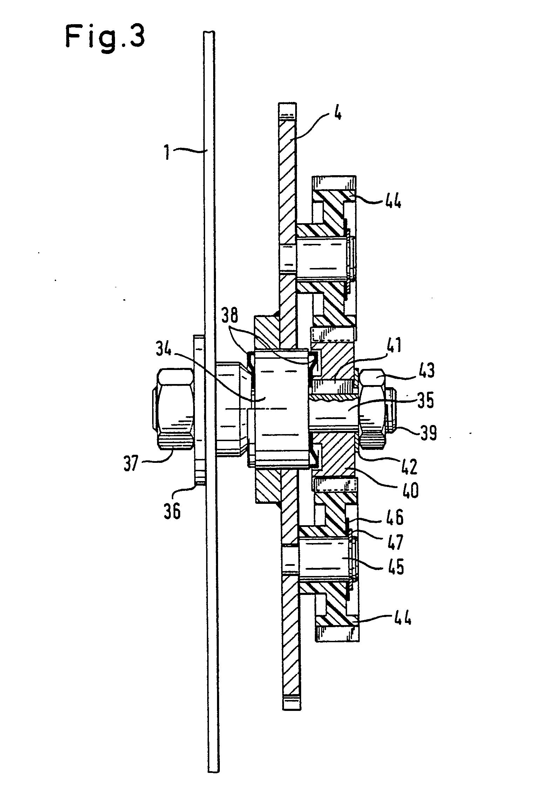

In dem folgenden sollen nunmehr unter Bezugnahme auf Fig. 3 jene Meßnahmen beschrieben werden, mit welchen erreicht wird, daß diese Position der Magazinkästen 2 bei einer Änderung der Führungsrichtung der beiden Endlosketten 3 um 90 oder 180° aufrechterhalten wird.

Gemäß Fig. 3 erfolgt die Umlenkung der Endlosketten 3 mit Hilfe der bereits in Fig. 1 gezeigten Umlenkkettenrädern 4, welche jeweils unter Einsatz eines entsprechenden Wälzlagers 34 auf einem Bolzen 35 gelagert sind, wobei diese einzelnen Bolzen 35 unter Einsatz von Scheiben 36 und jeweils einer Mutter 37 an einem Rahmen oder unmittelbar an der Wandung des äußeren Gehäuses 1 befestigt sind. Seitlich von dem Wälzlager 34 sind zusätzlich zwei Dichtringe 38 vorgesehen, mit welchen eine Abdichtung des jeweiligen Wälzlagers 34 erreicht wird.

Zur Mitte des Abgebegerätes hin weisen die einzelnen Bolzen 35 jeweils einen Gewindeansatz 39 auf, auf welchem ein Stirnzahnrad 40 unter Einsatz einer Paßfeder 41, einer Fächerscheibe 42 und einer Mutter 43 drehfest befestigt ist. Dieses Stirnzahnrad 40 bildet dabei ein Sonnenrad, welches mit vier jeweils um 90° gegeneinander versetzten Planetenrädern 44 kämmt, welche ebenfalls als Stirnzahnräder ausgebildet sind. Diese vier Planeteträger 44 sind dabei auf Zapfen 45 gelagert, welche an dem jeweiligen Umlenkkettenrad 4 befestigt sind. Die betreffenden Planetenräder 44 sind dabei mit Hilfe entsprechender Scheiben 46 und Sicherungsringen 47 gegenüber den Zapfen 45 der Umlenkkettenräder 4 positionsmäßig fixiert. Diese Planetenräder 44 bestehen dabei aus einem selbstschmierenden Kunststoff, so daß auf besondere Schmiermaßnahmen der Planetenräder 46 verzichtet werden kann.

Die in Fig. 2 gezeigten Halteelemente 13 sind entlang ihres Umfangs ebenfalls mit einem Zahnkranz 48 versehen, so daß diese Halteelemente 13 im wesentlichen ebenfalls Stirnzahnräder bilden. Im Bereich einer Umlenkung der Endlosketten 3 durch die Umlenkkettenräder 4 gelangen die Zahnkränze 48 von jsweils einem Paar von Halteelementen 13 in kämmenden Eingriff mit den außermittig an den Umlenkkettenrädern 4 befestigten Planetenrädern 44, welche aufgrund der Drehung der Umlenkkettenräder 4 bei stationär gehaltenem Sonnenrad 40 derart rotieren, daß je nachdem, ob im Bereich des betreffenden Umlenkkettenrades 4 eine Kettenumlenkung um 90 oder 180° vorgenommen wird, eine entsprechende Verschwenkung der jeweils paarig angeordneten Halteelemente 3 in bezug auf die richtungsmäßig gegenüber den Endlosketten 3 ausgerichteten Scheiben 19 zustande kommt, so daß insgesamt die horizontale Ausrichtung der Magazinkästen 2 innerhalb des Gehäuses 1 beibehalten wird. Die vorgesehene Verrastung der Rastkugeln 16 gegenüber den konischen Erweiterungen 17 der Bohrungen 18 ist dabei derart ausgebildet, daß selbst bei geringfügigem fehlerhaftem Einlauf oder Auslauf der Zahnkränze 48 der Halteelemente 3 auf die Verzahnung der Planetenräder 44 der Umlenkkettenräder 4 eine automatische Nachausrichtung der Halteelemente 3 und damit der von ihnen getragenen Magazinkästen 2 zustande kommt.

Um bei einer Umlenkung der Endlosketten 3 entlang der Umlenkkettenräder 4 eine genaue winkelmäßige Verschwenkung der jeweiligen Halteelemente 13 gegenüber den Scheiben 19 zu erreichen, erweist es sich als wichtig, daß das mittige Sonnenrad 40 und die auf den Halteelementen 13 vorgesehenen Zahnkränze 48 bei gleichem Durchmesser die gleiche Zähnezahl aufweisen.

Obwohl dies nicht absolut notwendig ist, erweist es sich fernerhin aus Einfachheitsgründen als am zweckmäßigsten, wenn ebenfalls die zwischen den Sonnenrädern 40 und den Zahnkränzen 48 der Halteelemente 13 laufenden Planetenräder 44 gleich groß dimensioniert werden, so daß diese Planetenräder 44 entlang ihres Umfangs ebenfalls die gleiche Zähnezahl besitzen. Dies wiederum führt dazu, daß der Durchmesser der Umlenkkettenräder 4 in etwa viermal so groß wie der Durchmesser der kleineren Stirnzahnräder 40, 44 und 48 gewählt werden muß.

Da die Ausrichtung der Magazinkästen 2 mit Hilfe der beiden Endlosketten 3 vorgenommen wird, erweist es sich als notwendig, daß diese Endlosketten 3 unter einer genau vorgegebenen Zugspannung gehalten werden. Aus diesem Grunde ist das Abgabegerät zusätzlich mit zwei nicht dargestellten Kettenspanneinrichtungen versehen, deren Druckfedern derart ausgebildet sind, daß die einzelnen Abschnitte der Endlosketten 3 konstant in etwa unter einer Zugspannung von 100 kg gehalten werden. Die betreffenden Kettenspanneinrichtungen sind jedoch vorzugsweise arretierbar, damit dieselben wärend des Anlaufs des Abgabegerätes nicht in ungewünschter Weise nachgeben können.

Aufgrund der im Rahmen der vorliegenden Erfindung vorgesehenen Anordnung ergibt sich die Möglichkeit, daß die beiden Endlosketten 3 mit einer Geschwindigkeit von bis zu 0,68 m/sec angetrieben werden, ohne daß dabei im Bereich der Umlenkkettenräder 4 derartige Winkelbeschleunigungsvorgänge auftreten, daß die innerhalb der Aufnahmemulden 5 befindlichen elektrischen Bauteile aufgrund von Trägheit aus den Magazinkästen 2 herausgeschleudert werden. Bei Verwendung von 74 Magazinkästen 2 innerhalb des Abgabegerätes ergibt sich bei einer derartigen Antriebsgeschwindigkeit der Endlosketten 3 eine Zugriffzeit von maximal 7 sec zu einer beliebigen der vorhandenen 592 Aufnahmemulden 5, was für die meisten hier in Frage kommenden Sonderbestückungsvorgänge ausreichend ist.

Der Vollständigkeit sei abschließend noch hervorgehoben, daß die im Umlenkbereich der beiden Endlosketten 3 vorgesehenen Umlenkkettenräder 4 derart dimensioniert werden müssen, daß ihre Zähnezahl einem ganzzahligen Vielfachen der Anzahl von Kettenglieder zwischen den in regelmäßigen Abständen hintereinander geförderten Magazinkästen 2 entspricht. Bei der beschriebenen Ausführungsform weisen die einzelnen Umlenkkettenräder 4 entlang ihres Umfanges jeweils 40 Zähne auf, während die Endlosketten 3 zwischen den einzelnen Magazinkästen 2 jeweils zehn Kettenglieder besitzen, so daß jeweils ein Magazinkasten 2 um 90° entlang des Umfanges eines Paares von Umlenkkettenrädern 4 geführt ist, bevor der nächste Magazinkasten 2 in den Bereich der durch die Umlenkkettenräder 4 gebildeten Umlenkanordnung gelangt, aus welchem Grunde bei der beschriebenen Ausführungsform jeweils vier Planetenräder 44 pro Umlenkkettenrad 4 vorgesehen sind. Unter Berücksichtigung der obigen Ausführungen ergibt sich ferner, daß die Gesamtlänge der beiden Endlosketten 3 ein ganzzahliges Vielfaches des von zwei benachbarten Planetenrädern 44 gebildeten Umfangssektors der Umlenkkettenräder 4 gewählt werden muß.

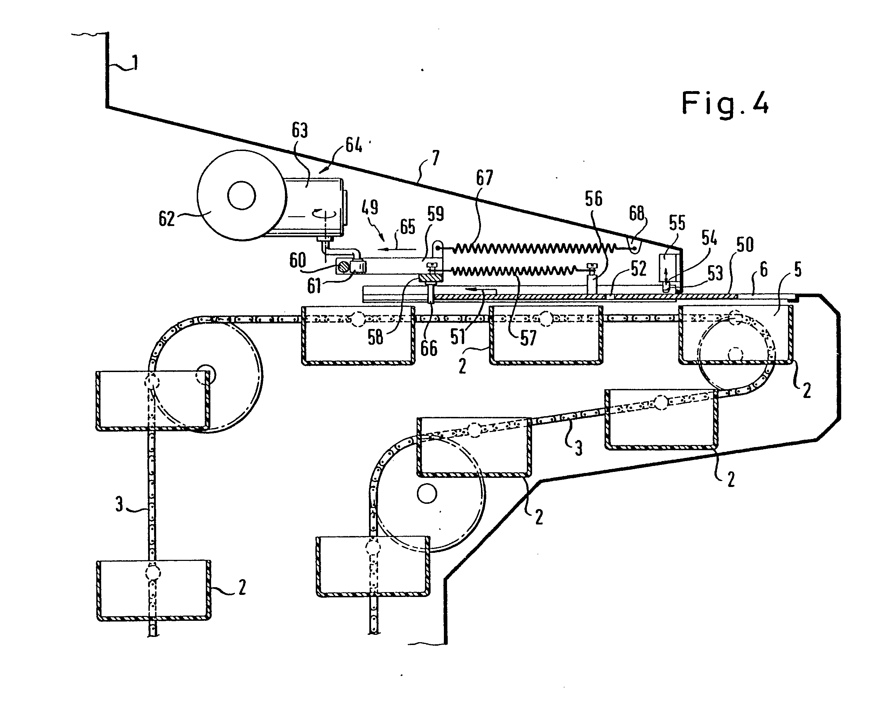

Bei dem bisher beschriebenen Abgabegerät werden die einzelnen Magazinkästen 2 jeweils einem im vorderen Bereich pultförmigen Ansatzes 7 angeordneten länglichen Entnahmefenster 6 zugeführt. Im Rahmen einer anhand von Fig. 4 zu beschreibenden Verschlußdeckelanordnung kann jedoch erreich werden, daß je nach dem jeweils durchzuführenden Bestückungsvorgang nur eine einzige Aufnahmemulde 5 innerhalb des länglichen Entnahmefensters 6 freigegeben wird, so daß ein bestimmtes Bauteil ohne Irrtumsmöglichkeit dem jeweiligen Abgabegerät entnommen werden kann. Die betreffende Verschlußdeckelanordnung ist dabei jedoch derart ausgebildet, daß in bestimmten Fällen ebenfalls ein gleichzeitiger Zugriff zu mehreren Abgabemulden 5 möglich ist, um auf diese Weise bei Verwendung von Magazinkästen 2 mit Spezialaufnahmemulden ein größeres Bauteil bzw. mehrere Bauteile gleichzeitig entnehmen zu können, so wie dies beispielsweise bei der Befestigung eines Bauteils mit Hilfe von Schrauben und Muttern erforderlich ist.

Mit Hilfe der in Fig. 4 gezeigten Verschlußdeckelanordnung 49 können die acht nebeneinander angeordneten Aufnahmemulden 5 der Magazinkästen 2 derart verschlossen werden, daß ein beliebiger Zugriff zu einer oder mehreren Aufnahmemulden 5 des im Bereich des Entnahmefensters 6 angeordneten Magazinkastens 2 möglich ist. Diese Verschlußdeckelanordnung 49 besitzt dabei zehn nebeneinander angeordnete, translatorisch verschiebbare Verschlußdeckel, von welchen die Verschlußdeckel mit Ausnahme der beiden äußeren dem Verschluß der nebeneinander angeordneten acht Aufnahmemulden 5 des jeweiligen Magazinkastens 2 dienen, während die beiden äußeren Verschlußdeckel eine derartige Breite besitzen, daß beim Zurückziehen aller zehn Verschlußdeckel eine Entnahme des gesamten Magazinkastens 2 durch die betreffende Entnahmeöffnung 4 möglich ist. Mit Ausnahme der Tatsache, daß der beiden äußeren Verschlußdeckel im Vergleich zu den im mittleren Bereich angeordneten Verschlußdeckeln eine geringere Breite besitzen, sind die einzelnen Verschlußdeckel ansonsten identisch ausgebildet.

Fig. 4 zeigt das äußere Gehäuse 1 des Abgabegerätes mit dem pultförmigen Ansatz 7, durch welchen eine horizontal verlaufende Schlaufe der beiden Endlosketten 3 geführt ist. Wie erkennbar, sind an diesen Endlosketten 3 in regelmäßigen Abständen die Magazinkästen 2 angelenkt, von welchen jeweils einer in den Bereich des länglichen Entnahmefensters 6 gelangt.

Die einzelnen Aufnahmemulden 5 des jeweiligen Magazinkastens 2 können von den verschiedenen Verschlußdeckeln abgedeckt werden, von welchen in Fig. 4 ein einzelner Verschlußdeckel 50 dargestellt ist. Der betreffende Verschlußdeckel 50 kann dabei unter Einsatz nicht dargestellter Kugelführungen in Richtung des Pfeiles 51 nach links bewegt werden, wodurch das Entnahmefenster 6 für die betreffende Aufnahmemulde 3 freigegeben wird.

Jeder Verschlußdeckel 50 ist mit einer Bohrung 52 versehen, in welche ein Zapfen 53 zum Eingreifen gelangt. Dieser Zapfen 53 ist Teil des beweglichen Ankers 54 eines oberhalb des Verschlußdeckels 50 angeordneten Hubmagnetens 55, welcher somit in seinem nicht aktivierten Zustand den Verschlußdeckel 50 in der vorgeschobenen Position verriegelt, in welcher die betreffende Aufnahmemulde 5 des Magazinkastens 2 verschlossen ist.

Die einzelnen Verschlußdeckel 50 sind fernerhin mit nach oben ragenden Zapfen 56 versehen, an welchen jeweils eine Zugfeder 57 eingehängt ist, deren anderes Ende an den Querbalken 58 eines translatorisch verschiebbaren Schlittens 59 befestigt ist. Dieser Schlitten 59 besitzt dabei eine Querstange 60, an welcher der Kurbelzapfen 61 eines aus einem Elektromotor 62 und einem Untersetzungsgetriebe 63 bestehenden Scheibenwicherantriebes 64 zum Eingreifen gelangt. Mit Hilfe dieses Scheibenwischerantriebes 64 kann somit durch Kraftbeaufschlagung der Querstange 60 der Schlitten 59 in Richtung des Pfeiles 65 bewegt werden, wodurch über die einzelnen Zugfedern 57 hinweg die verschiebbaren Verschlußdeckel 50 mitbewegt werden, falls durch Aktivierung des entsprechenden Hubmagneten 55 der am unteren Ende vorgesehene Zapfen 56 aus der Bohrung 52 des jeweiligen Verschlußdeckels 60 herausgezogen worden ist.

Die Rückführung der Verschlußdeckel 50 in ihre Verschlußposition, in welcher die einzelnen Aufnahmemulden 5 des betreffenden Magazinkastens 2 abgedeckt sind, erfolgt mit Hilfe von Zapfen 66, welche von dem Querbalken 58 des Schlittens 59 nach unten ragen und gegen das Ende der Verschlußdeckel 50 drücken. Da jedoch mit Hilfe des Kurbelzapfens 61 des Scheibenwischerantriebs 64 keine zwangsweise Rückführung des Schlittens 59 in seine Ausgangsposition erfolgt, sind an den beiden Enden des Querbalkens 58 des Schlittens 59 zwei zusätzliche Zugfedern 67 vorgesehen, welche parallel zu den Zugfedern 57 angeordnet sind. Im Gegensatz zu den Zugfedern 57 sind jedoch diese zwei zusätzlichen Zugfedern 67 unmittelbar an einem feststehenden Gehäuseteil 68 eingehängt, so daß sie eine Zurückführung des Schlittens 59 selbst dann bewirken, wenn alle Hubmagneten 55 aktiviert sind und somit alle Zugfedern 57 aufgrund des Nachziehens der verschiebbaren Verschlußdeckel 50 unter geringer Zugspannung stehen. Auf diese Weise kann erreicht werden, daß die einzelnen Verschlußdeckel 50 mit relativ geringer Kraft zurück in ihre Verschlußstellung geschoben werden, so daß keine Verletzungsgefahr besteht, falls die den jeweiligen Bestückungsvorgang durchführende Bedienungsperson zu lange ihre Finger innerhalb der jeweils geöffneten Aufnahmemulde 5 hält.

Zusammenfassend ergibt sich somit, daß mit Hilfe der beschriebenen Verschlußdeckelanordnung 49 unter Einsatz eines einzigen Elektroantriebes 64 eine beliebige Anzahl von translatorisch verschiebbarer Verschlußdeckel 50 gleichzeitig geöffnet werden kann, wobei die Freigabe der einzelnen Verschlußdeckel 50 in Abhängigkeit der Aktivierung zugeordneter Hubmagnete 55 erfolgt. Sowohl die Öffnung wie auch die Schließung der einzelnen Veschlußdeckel 50 erfolgt dabei mit Hilfe zwischengeschalteter Zugfedern 57, 67, so daß ungewünschte Betriebsstörungen weitgehend ausgeschlossen sind.

**Patentansprüche**

1. Abgabegerät zur gesteuerten Abgabe einer Vielzahl verschiedener Bauteile, beispielsweise elektrischer Bauteile für die Durchführung eines Bestückungsvorganges von Schaltplatinen, bestehend aus einer Mehrzahl von länglichen, jeweils mehrere Aufnahmemulden (5) aufweisenden Magazinkästen (2), welche mit Hilfe zweier jeweils seitlich angeordneter angetriebener Endlosketten (3) in der Art eines Paternosterförderers über Umlenkkettenräder (4) in den Bereich eines Entnahmefensters (6) bewegbar sind, wobei die beiden Endlosketten (3) in regelmäßigen Abständen mit zur Mitte hin vorspringenden Zapfen (12) versehen sind, an welchen der Halterung der Magazinkästen (2) dienende Elemente (13) drehbar angeordnet sind, und wobei zusätzlich eine Zwangsführung vorgesehen ist, mit welcher die einzelnen Magazinkästen (2) mit ihren Aufnahmemulden (5) während ihrer Bewegung entlang des Entnahmefensters (6) in einer vorgegebenen Winkellage gehalten sind, dadurch gekennzeichnet, daß diese der Halterung der Magazinkästen (2) dienenden Elemente als drehbar gelagerte Halteelemente (13) ausgebildet sind, welche mit Rastgliedern (16) versehen sind, die in bezug auf die Endlosketten (3) in vorgegebenen Winkelstellungen einrastbar sind.

2. Abgabegerät nach Anspruch 1, dadurch gekennzeichnet, daß die der Halterung der Magazinkästen (2) dienenden Halteelemente (13) in Form von Zahnrädern (48) ausgebildet sind, welche im Umlenkbereich der beiden Endlosketten (3) mit entsprechenden Planetenrädern (44) in kämmenden Eingriff gelangen, und daß diese Planetenräder (44) mittels Zapfen (45) drehbar auf den Umlenkkettenrädern (4) der Endlosketten (3) befestigt sind und gleichzeitig mit einem drehfest auf der Achse (35) des betreffenden Umlenkkettenrades (4) befestigten Sonnenrad (40) kämmen.

3. Abgabegerät nach Anspruch 2, dadurch gekennzeichnet, daß die der Halterung der Magazinkästen (2) dienenden Halteelemente (13), die von den Umlenkkettenrädern (4) getragenen Planetenräder (44), sowie die drehfest auf den Achsen (35) der Umlenkkettenräder (4) befestigten Sonnenräder (40) in Form von Stirnzahnrädern ausgebildet sind, welche den gleichen Durchmesser, die gleiche Zahnteilung und die gleiche Zähnezahl aufweisen.

4. Abgabegerät nach Anspruch 2 oder 3, dadurch gekennzeichnet, daß an den einzelnen Umlenkkettenrädern (4) vier jeweils um 90° gegeneinander versetzte Planetenräder (44) drehbar gelagert sind.

5. Abgebegerät nach einem der vorhergehenden Ansprüche, dadurch gekennzeichnet, daß auf den zur Mitte hin vorspringenden Zapfen (12) der beiden Endlosketten (3) jeweils eine Scheibe (19) drehbar gelagert ist, welche im Umfangsbereich mit Bohrungen (18) versehen ist, und daß in eine dieser Bohrungen (18) von der einen Seite her ein von dem benachbarten Kettenglied vorspringender Zapfen (23) in Eingriff gelangt, während von der anderen Seite her eine federbeaufschlagte Rastkugel (6) des Halteelementes (13) in eine entsprechende konische Erweiterung (17) der Bohrung (18) drückbar ist.

6. Abgabegerät nach Anspruch 6, dadurch gekennzeichnet, daß die drehbar auf dem Zapfen (12) der Endlosketten (3) gelagerten Scheiben (19) mit vier jeweils um 90° gegeneinander versetzten Bohrungen (18) versehen sind, und daß die die Magazinkästen (2) tragenden Halteelemente (13) mit zwei um jeweils 180° gegeneinander versetzten zylindrischen Kammern (14) versehen sind, welche der Aufnahme von jeweils einer Druckfeder (15) und einer Rastkugel (16) dienen.

7. Abgabegerät nach einem der vorhergehenden Ansprüche, dadurch gekennzeichnet, daß die beidseitig von den Magazinkästen (2) vorgesehenen Halteelemente (13) nach unten hin jeweils Ansätze (30) aufweisen, welche mit Bohrungen (31) versehen sind, und daß durch diese Bohrungen (31) hindurch Stangen (32) geführt sind, welche jeweils ein Paar von Halteelementen (13) untereinander verbinden.

8. Abgabegerät nach Anspruch 7, dadurch gekennzeichnet, daß die Stangen als Vierkantstäbe (32) ausgebildet sind welche durch entsprechende Vierkantbohrungen (31) als Halteelemente (13) geführt sind.

9. Abgabegerät nach einem der vorhergehenden Ansprüche, dadurch gekennzeichnet, daß die Halteelemente (13) zur Mitte hin mit horizontal verlaufenden Vorsprüngen (28) versehen sind, auf welchen die Magazinkästen (2) seitlich zum Aufliegen gelangen, und daß die Halteelemente (13) zusätzlich vertikal verlaufende Stege (29) aufweisen, welche im eingesetzten Zustand der Magazinkästen (2) in entsprechende Vertikalnuten der Magazinkästen (2) zu liegen gelangen.

10. Abgabegerät nach Anspruch 9, dadurch gekennzeichnet, daß die Vertikalstege (29) der auf beiden Seiten vorgesehenen Halteelemente (13) und die auf beiden Seiten der Magazinkästen (2) vorgesehenen Vertikalnuten jeweils eine unterschiedliche Breite aufweisen, demzufolge die Magazinkästen (2) nur in einer Position in die entsprechenden Paare von Halteelemente (13) einsetzbar sind.

11. Abgabegerät nach einem der vorhergehenden Ansprüche, dadurch gekennzeichnet, daß den einzelnen Aufnahmemulden (5) der Magazinkästen (2) im Bereich des Entnahmefensters (6) translatorisch verschiebbare Verschlußdeckel (50) zugeordnet sind, welche mit Hilfe entsprechender Hubmagnete (55) in der Verschlußstellung arretierbar sind, und daß die verschiebbaren Verschlußdeckel (50) über entsprechende Zugfedern (57) mit einem ebenfalls translatorisch verschiebbaren Schlitten (59) verbunden sind, welcher mit Hilfe eines Elektromotors (62) hin- und herbewegbar ist.

12. Abgabegerät nach Anspruch 11, dadurch gekennzeichnet, daß der translatorisch verschiebbare Schlitten (50) mit Anschlagflächen in Form von nach unten ragenden Zapfen (66) versehen ist, mit welchen die verschiebbaren Verschlußdeckel (50) in die vordere Verschlußstellung drückbar sind.

13. Abgabegerät nach Anspruch 12, dadurch gekennzeichnet, daß der translatorisch verschiebbare Schlitten (59) mit Hilfe weiterer Zugfedern (67) in eine Position gedrückt ist, in welche die an dem Schlitten (59) angebrachten Zapfen (66) einen Verschluß des Entnahmefensters (6) bewirken, und daß der Schlitten (59) mit einer Querstange (60) versehen ist, an welcher ein an dem Untersetzungsgetriebe (63) des Elektromotors (62) vorgesehener Kurbelzapfen (61) zum Anliegen gelangt, welcher den Schlitten (59) in seine den Öffnungsvorgang der Verschlußdeckel (50) auslösende Stellung drängt.

14. Abgabegerät nach einem der vorhergehenden Ansprüche, dadurch gekennzeichnet, daß die einzelnen Verschlußdeckel (50) mit Bohrungen (52) versehen sind, in welche entsprechende Zapfen (53) am vorderen Ende der betreffenden Hubmagnete (55) zum Eingreifen gelangen.

15. Abgabegerät nach einem der vorhergehenden Ansprüche, dadurch gekennzeichnet, daß auf beiden Seiten der den einzelnen Aufnahmemulden (5) zugeordneten Verschlußdeckel (50) jeweils ein weiterer verschiebbarer Verschlußdeckel vorgesehen ist, demzufolge bei gleichzeitiger Öffnung aller den Aufnahmemulden (3) zugeordneten Verschlußdeckel (50) sowie der zwei zusätzlichen Verschlußdeckel eine Entnahme bzw. Austausch des gesamten Magazinkastens (2) durchführbar ist.

16. Abgabegerät nach Anspruch 15, dadurch gekennzeichnet, daß bei Vorhandensein von acht Aufnahmemulden (5) je Magazinkasten (2) insgesamt zehen verschiebbare Verschlußdeckel (50) vorgesehen sind, welche über zehn parallel zueinander angeordnete Zugfedern (57) mit der Querstange (60) des Schlittens (59) verbunden sind, und daß an den beiden Enden dieser Querstange (60) des Schlittens (59) zwei weitere Zugfedern (67) angreifen, welche den verschiebbaren Schlitten (59) in seine vordere Position drängen.

17. Abgabegerät nach Anspruch 16, dadurch gekennzeichnet, daß die verschiedenen Zugfedern (57, 67) derart ausgelegt sind, daß dieselben im nicht aktivierten Zustand der Verschlußdeckel (50) und des Schlittens (59) im wesentlichen spannungslos sind.

18. Abgabegerät nach Anspruch 16 oder 17, dadurch gekennzeichnet, daß die Verschlußdeckel (50) und der Schlitten (59) auf Kugelführungsschienen gelagert sind.

19. Abgabegerät nach einem der vorhergehenden Ansprüche, dadurch gekennzeichnet, daß dasselbe mit einem pultförmigen Ansatz (7) versehen ist, welcher in seinem vorderen Bereich nach oben hin mit dem Entnahmefenster (6) versehen ist.

20. Abgabegerät nach Anspruch 19, dadurch gekennzeichnet, daß der pultförmigen Ansatz (7) derart dimensioniert ist, daß auf demselben neben Halteelementen für eine zu bestückende Platine eine den jeweiligen Bestückungsort optisch mit Hilfe eines Lichtstrahls anzeigende Leuchtpunktanzeige befestigbar ist.

## Revendications

1. Distributeur pour la distribution d'un certain nombre de pièces différentes, par exemple, des pièces électriques pour l'accomplissement d'un processus d'équipement de plaquettes à circuits imprimés, se composant d'un certain nombre de cases longitudinales (2) présentant chacune plusieurs cavités de réception (5) lesquelles cases sont mobiles, à l'aide de deux chaînes sans fin entraînées et agencées latéralement (3), à la façon d'un alimentateur à chapelets, au moyen de roues de changement de direction (4), dans la zone d'une fenêtre de prélèvement (6), les deux chaînes sans fin (3) étant pourvues, à des distances régulières, de tourillons (12) dépassant vers le milieu où sont agencés rotatifs des éléments (13) servant à la retenue des cases (2) et en ce que de plus un guidage forcé est prévu, au moyen duquel les cases individuelles (2) sont maintenues avec leurs cavités de réception (5), pendant leur mouvement le long de la fenêtre de prélèvement (6), à une position angulaire prédéterminée, caractérisé en ce que ces éléments servant à la retenue des cases (2) sont configurés en tant qu'éléments de retenue (13) logés rotatifs qui sont pourvus d'organes d'arrêt (16) qui peuvent s'enclencher par rapport aux chaînes sans fin (3) à des positions angulaires prédéterminées.

2. Distributeur selon la revendication 1, caractérisé en ce que les éléments de retenue (13) servant à la retenue des cases (2) ont la forme de roues dentées (48) qui viennent en prise dans la zone de changement de direction des deux chaînes sans fin (13) avec des satellites correspondants (44) et en ce que ces satellites (44) sont fixés rotatifs au moyen de tourillons (45) sur les roues (4) des chaînes sans fin (3) et s'enclenchent simultanément avec un pignon soleil (40) fixé stationnaire en rotation sur l'axe (35) de la roue correspondante de changement de direction (4).

3. Distributeur selon la revendication 2, caractérisé en ce que les éléments de retenue (13) servant à la retenue des cases (2), les satellites (44) portés par les roues de changement de direction (4) ainsi que les pignons soleils (40) fixés stationnaires sur les axes (35) des roues (4) ont la forme de roues à denture frontale qui présentent le même diamètre, la même répartition des dents et le même nombre de dents.

4. Distributeur selon la revendication 2 ou 3, caractérisé en ce que sur chaque roue (4) sont logés rotatifs quatre satellites (44) mutuellement décalés de 90°.

5. Distributeur selon l'une quelconque des revendications précédentes, caractérisé en ce que sur les tourillons (12), dépassant vers le milieu, des deux chaînes sans fin (3) est logé rotatif un disque (19) qui est pourvu, dans sa zone périphérique, de perçages (18) et en ce que dans l'un de ces perçages (18) s'enclenche un tourillon (23) dépassant d'un côté du maillon voisin de chaîne tandis que de l'autre côté une bille d'arrêt (6) sollicitée par ressort de l'élément de retenue (13) peut être pressée dans un élargissement conique correspondant (17) du perçage (18).

6. Distributeur selon la revendication 6, caractérisé en ce que les disques (19) logés rotatifs sur les tourillons (12) des chaînes sans fin (3) sont pourvus de quatre perçages (18) mutuellement décalés de 90° et en ce que les éléments de retenue (13) portant les cases (2) sont pourvus de chambres (14) cylindriques mutuellement décalées de 180°, qui servent à la réception d'un ressort de compression (15) et d'une bille d'arrêt (16).

7. Distributeur selon l'une quelconque des revendications précédentes, caractérisé en ce que les éléments de retenue (13) prévus des deux côtés des cases (2) présentent des saillies (30) dirigées vers le bas, qui sont pourvues de perçages (31) et en ce que des tiges (32) sont guidées à travers ces perçages (31), qui relient l'un à l'autre deux éléments de retenue (13).

8. Distributeur selon la revendication 7, caractérisé en ce que les tiges ont la forme de tiges (32) à quatre pans qui sont guidées à travers des perçages à quatre pans correspondants (31) en tant qu'éléments de retenue (13).

9. Distributeur selon l'une quelconque des revendications précédentes, caractérisé en ce que les éléments de retenue (13) sont pourvus, vers le milieu, de saillies horizontales (28) sur lesquelles viennent reposer latéralement les cases (2) et en ce que les éléments de retenue (13) présentent de plus des nervures verticales (29) qui, à l'état mise en place des cases (2), viennent reposer dans des rainures verticales correspondantes des cases (2).

10. Distributeur selon la revendication 9, caractérisé en ce que les nervures verticales (29) des éléments de retenue (13) prévus des deux côtés et les rainures verticales prévues des deux côtés des cases (2) présentent une largeur différente et par suite les cases (2) ne peuvent être utilisées qu'à une position dans la paire correspondante des éléments de retenue (13).

11. Distributeur selon l'une quelconque des revendications précédentes, caractérisé en ce qu'aux cavités individuelles de réception (5) des cases (2) sont affectés, dans la zone de la fenêtre de prélèvement (6), des couvercles de fermeture (50) mobiles en translation qui peuvent être bloqués à la position de fermeture à l'aide d'aimants correspondants de levage (55) et en ce que les couvercles mobiles de fermeture (50) sont reliés par des ressorts correspondants de traction (57) à un chariot (59) également mobile en translation, qui est mobile en va-et-vient à l'aide d'un moteur électrique (62).

12. Distributeur selon la revendication 11, caractérisé en ce que le chariot mobile en translation (50) est pourvu de surfaces de butée sous la forme de tourillons (66) dépassant vers le bas, par lesquels les couvercles mobiles de fermeture (50) peuvent être pressés à la position avant de fermeture.

13. Distributeur selon la revendication 12, caractérisé en ce que le chariot mobile en translation (59) est pressé à l'aide d'autres ressorts de compression (67) à une position dans laquelle les tourillons (66) prévus sur le chariot (59) effectuent une fermeture de la fenêtre de prélèvement (6) et en ce que le chariot (59) est pourvu d'une traverse (60) sur laquelle vient s'appuyer un tourillon de manivelle (61) prévu sur le démultiplicateur (63) du moteur électrique (62), qui presse le chariot (59) à sa position déclenchant le processus d'ouverture du couvercle (50).

14. Distributeur selon l'une quelconque des revendications précédentes, caractérisé en ce que chaque couvercle de fermeture (50) est pourvu de perçages (52) dans lesquels s'enclenchent des tourillons correspondants (53) à l'extrémité avant des ressorts correspondants de levage (55).

15. Distributeur selon l'une quelconque des revendications précédentes, caractérisé en ce que des deux côtés des couvercles de fermeture (50) affectés à chacune des cavités de réception (5) est prévu un autre couvercle mobile de fermeture et par suite, avec l'ouverture simultanée de tous les couvercles de fermeture (50) affectés à toutes les cavités de réception (3) ainsi que des deux couvercles supplémentaires de fermeture, on peut accomplir un prélèvement ou respectivement un échange de la totalité de la case (2).

16. Distributeur selon la revendication 15, caractérisé en ce que dans le cas de la présence de huit cavités de réception (5), en tout dix couvercles mobiles de fermeture (50) sont prévus pour chaque case (2), lesquels sont reliés au moyen de dix ressorts de traction parallèles les uns aux autres (57) à la traverse (60) du chariot (59) et en ce qu'aux deux extrémités de cette traverse (60) du chariot (59) agissent deux autres ressorts de traction (67) qui pressent le chariot mobile (59) à sa position avant.

17. Distributeur selon la revendication 16, caractérisé en ce que les divers ressorts de traction (57, 67) sont agencés de manière qu'à l'état non activé, le couvercle de fermeture (50) et le chariot (59) soient essentiellement sans tension.

18. Distributeur selon l'une quelconque des revendications 16 ou 17, caractérisé en ce que le couvercle de fermeture (50) et le chariot (59) sont logés sur des rails sphériques de guidage.

19. Distributeur selon l'une quelconque des revendications précédentes, caractérisé en ce qu'il est pourvu d'une saillie (7) en forme de pupitre qui est pourvue, à sa zone avant, vers le haut, de la fenêtre de prélèvement (6).

20. Distributeur selon la revendication 19, caractérisé en ce que la saillie (7) en forme de pupitre est dimensionnée de manière que l'on puisse y fixer, outre les éléments de retenue pour une platine à équiper, un indicateur par points lumineux indiquant, à l'aide d'un rayon lumineux, optiquement, la position de chaque équipement.

## Claims

1. Delivery unit for the controlled delivery of a plurality of different components, e.g. electrical components for loading printed circuit boards, comprising a plurality of elongated magazines (2), in each case having several trays (5) and which with the aid of two laterally positioned, driven chain belts (3) in the manner of a paternoster conveyor are movable by means of guide sprocket wheels (4) into the vicinity of a removal window (6), the two chain belts (3) being provided at regular intervals with pins (12) projecting towards the centre, on which the members (13) for retaining the magazines (2) are located in rotary manner and in which additionally a forced guidance is provided ensuring that the individual magazines (2) with their trays (5) are kept in a predetermined angular position during their movement along the removal window (6) characterized in that the members serving to retain the magazines (2) are constructed as rotatably mounted retaining members (13), which are provided with locking members (16), which can be locked in predetermined angular positions with respect to the chain belts (3).

2. Delivery unit according to Claim 1, characterized in that the retaining members (13) for mounting the magazines (2) are constructed in the form of gear wheels (48) which, in the reversing area of the two chain belts (3) mesh with corresponding planetary gears (44) and that said planetary gears (44) are fixed in rotary manner to the guide sprocket wheels (4) of the chain belts (3) by means of pins (45) and simultaneously mesh with a sun gear fixed in non-rotary manner to the shaft (35) of the particular guide sprocket wheel (4).

3. Delivery unit according to Claim 2, characterized in that the retaining members (13) for mounting the magazines (2), the planetary gears (44) carried by the guide sprocket wheels (4) and the sun gears (40) fixed in non-rotary manner to the shafts (35) of wheels (4) are constructed in the form of spur gears, which have the same diameter, the same pitch and the same number of teeth.

4. Delivery unit according to Claims 2 or 3, characterized in that on the individual guide sprocket wheels (4) are mounted in rotary manner four planetary gears (44) reciprocally displaced by 90°.

5. Delivery unit according to one of the preceding claims, characterized in that a disk (19) is mounted in rotary manner on each of the pins (12) of the two chain belts (3) projecting towards the centre and are provided in the circumferential area with bores (18) and a pin (23) projecting from the adjacent chain link engages from one side in one of said bores (18), whilst from the other side a spring-loaded locking ball (6) of the retaining member (13) can be pressed into a corresponding conical widened portion (17) of bore (18).

6. Delivery unit according to Claim 6, characterized in that the disks (19) mounted in rotary manner on the pins (12) of the chain belts (9) are provided with four bores (18) reciprocally displaced by 90° and that the retaining members (13) carrying the magazines (2) are provided with two cylindrical chambers (14) reciprocally displaced by 180° and which are used for receiving in each case one compression spring (5) and a locking ball (16).

7. Delivery unit according to one of the preceding claims, characterized in that the retaining members (13) provided on either side of the magazines (2) have towards the bottom steps (30), which are provided with bores (31) and that through the latter are passed rods (32), which in each case interconnect a pair of retaining members (13).

8. Delivery unit according to Claim 7, characterized in that the rods are constructed as square rods (32) which are passed through corresponding square bores (31) as retaining members (13).

9. Delivery unit according to one of the preceding claims, characterized in that towards the centre, the retaining members (13) are provided with horizontally directed projections (28), on which are laterally engaged the magazines (2) and that the retaining members (13) additionally have vertically directed webs (29), which in the inserted state of the magazines (2) come to rest in corresponding vertical slots of the latter.

10. Delivery unit according to Claim 9, characterized in that the vertical webs (29) of the retaining members (13) provided on both sides and the vertical slots provided on both sides of the magazines (2) in each case have a different width, so that the magazines (2) can only be inserted in one position in the corresponding pairs of retaining members (13).

11. Delivery unit according to one of the preceding claims, characterized in that with the individual trays (5) of the magazines (2) are associated in the vicinity of the removal window (6) covers (50) which are displaceable in translatory manner, which can be secured with the aid of corresponding lifting magnets (55) in the closure position and that the displaceable covers (50) are connected by means of corresponding tension springs (57) with a slide (59), which is also displaceable in translatory manner and which is reciprocatable with the aid of an electric motor (62).

12. Delivery unit according to Claim 11, characterized in that the translatory slide (50) is provided with stop faces in the form of downwardly projecting pins (66), with which the displaceable covers (50) can be pressed into the front closure position.

13. Delivery unit according to Claim 12, characterized in that the translatory slide (59) is pressed with the aid of further tension springs (67) into a position in which the pins (66) fitted to the slide (59) bring about a closure of the removal window (6) and the slide (59) is provided with a crossbar (60), on which engages a crank pin (61) provided on the reduction gear (63) of electric motor (62) and which urges the slide (59) into a position initiating the opening process of the cover (50).

14. Delivery unit according to one of the preceding claims, characterized in that the individual covers (50) are provided with bores (52), in which engage corresponding pins (53) at the front end of the particular lifting magnet (55).

15. Delivery unit according to one of the preceding claims, characterized in that on either side of the covers (50) associated with the individual trays (5) is provided a further displaceable cover and consequently it is possible to remove or replace the complete magazine (2) in the case of the simultaneous opening of all the covers (50) associated with the trays (3), as well as the two additional covers.

16. Delivery unit according to Claim 15, characterized in that when there are eight trays (5) per magazine (2), a total of ten displaceable covers (50) are provided, which are connected via ten parallel tension springs (57) to the crossbar (60) of slide (59) and that two further tension springs (67) engage on the two ends of said crossbar (60) of slide (59) which urge the displaceable slide (59) into its front position.

17. Delivery unit according to Claim 16, characterized in that the different tension springs (57, 67) are designed in such a way that in the unactivated state of the covers (50) and slide (59) are substantially tension-free.

18. Delivery unit according to Claims 16 or 17, characterized in that the covers (50) and slide (59) are mounted on ball guide rails.

19. Delivery unit according to one of the preceding claims, characterized in that it is provided with a desk-shaped step (7), which in its front area is provided towards the top with a removal window (6).

20. Delivery unit according to Claim 19, characterized in that the desk-shaped step (7) is dimesioned in such a way that, apart from retaining members for a printed circuit board to be loaded, to it can be fixed a luminous spot display optically indicating with the aid of a light beam the particular loading point.

# Fig.1

Fig.2

Fig.3

Fig.4

EP 0 258 249 B1